(19) Europäisches Patentamt
European Patent Office
Office européen des brevets

(11) EP 1 858 108 A1

(12) **EUROPEAN PATENT APPLICATION**
published in accordance with Art. 158(3) EPC

(43) Date of publication:
**21.11.2007 Bulletin 2007/47**

(21) Application number: **06712381.0**

(22) Date of filing: **26.01.2006**

(51) Int Cl.:
***H01M 14/00*** *(2006.01)* ***H01L 31/04*** *(2006.01)*

(86) International application number:
**PCT/JP2006/301199**

(87) International publication number:
**WO 2006/080384 (03.08.2006 Gazette 2006/31)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **27.01.2005 JP 2005019178**

(71) Applicant: **NIPPON KAYAKU KABUSHIKI KAISHA**
**Tokyo 102-8172 (JP)**

(72) Inventors:
- **INOUE, Teruhisa**
**Funct. Chemicals R&D Lab.**
**Tokyo 1150042 (JP)**
- **SHIGAKI, Koichiro**
**Funct. Chemicals R&D Lab.**
**Tokyo 1150042 (JP)**
- **HOSHI, Takayuki**
**Funct. Chemicals R&D Lab.**
**Tokyo 1150042 (JP)**
- **KANEKO, Masayoshi**
**Funct. Chemicals R&D Lab.**
**Tokyo 1150042 (JP)**

(74) Representative: **Gille Hrabal Struck Neidlein Prop Roos**
**Patentanwälte**
**Brucknerstrasse 20**
**40593 Düsseldorf (DE)**

# (54) MODIFIED TITANIUM OXIDE MICROPARTICLE AND PHOTOELECTRIC TRANSDUCER MAKING USE OF THE SAME

(57) [PROBLEMS] To develop metal microparticles useful in dye-sensitized solar cell, etc. and to provide a photoelectric transducer capable of exhibiting enhanced release voltage in dye-sensitized solar cell.

[MEANS FOR SOLVING PROBLEMS] There are provided modified titanium oxide microparticles comprised of titanium oxide and one or two or more types of nontitanic metal oxides (including silicon oxides) selected from the group consisting of periodic-table group IB oxides, group IIA oxides, group IIB oxides, group IIIA oxides, group IIIB oxides, group IVA oxides other than titanium oxides, group IVB oxides, group VIA oxides, group VIII oxides and vanadium oxides. Further, there is provided a photoelectric transducer making use of the modified titanium oxide microparticles.

EP 1 858 108 A1

**Description**

Technical Field

The present invention relates to modified titanium oxide microparticles, a method of manufacturing the same, and a photoelectric conversion device using the same.

Background of the Invention

Solar cells attracting an attention as a clean energy source have been used for ordinary houses in recent years; however, they have not yet been widely spread. The reasons therefor include that the module is obliged to be enlarged because the performance of a solar cell itself is hardly excellent enough, that the productivity in manufacturing the module is low, that as a result the solar cell itself becomes expensive, and the like.

Although there are several types of solar cells, most of the solar cells put to practical use are silicon solar cells. However, recently, a dye-sensitized solar cell attracts an attention, and its research is being made aiming at a practical use. The dye-sensitized wet solar cells have been researched for many years, and the basic structure is usually comprised of a semiconductor such as a metal oxide, a dye adsorbed thereto, an electrolytic solution, and a counter electrode. For the dye and the electrolytic solution among these, various types have been investigated, but the research reports on the semiconductor have been limited in their variety. In the early dye-sensitized wet solar cells, semiconductor single crystal electrodes, such as titanium oxide ($TiO_2$), zinc oxide (ZnO), cadmium sulfide (CdS), tin oxide ($SnO_2$), and the like have been used. However, they have demerits that the conversion efficiency is extremely low and their cost is high because the dye adsorption capacity of a single crystal electrode is small. The method proposed to improve this is the one in which a semiconductor having a large surface area, in which micro microparticles are sintered to provide a lot of fine pores, is used as the electrode, and Tsubomura et al. report that the performance of the electrode using such porous zinc oxide that adsorbed an organic dye is extremely high (Patent Document 1).

Thereafter, Graetzel (Switzerland) et al. developed a new type photoelectric (solar) cell using a photoelectric conversion device in 1991. This is also called a Graetzel cell, which is comprised of: a thin film substrate serving as one electrode, the thin film substrate being sensitized with a dye on a transparent conductive substrate and being composed of an oxide semiconductor microparticle; a substrate comprised of a counter electrode, the counter electrode being provided with a reducing agent such as platinum and being arranged so as to face to the thin film substrate; and a charge transfer layer (electrolyte containing a redox substance) being interposed between the thin film substrate and the substrate. Here, adsorption of a ruthenium complex dye to a porous titanium oxide electrode has permitted this new type photoelectric cell to have a performance close to the silicon solar cell (non-Patent Document 1). However, regarding such dye-sensitized type solar cells, significant improvement in the energy conversion efficiency has not been obtained since then. Moreover, the silicon solar cell is expensive, and also as a substitution thereof there is a need for further improvement and the like in the conversion efficiency of the dye-sensitized type solar cells.

The main factors affecting the conversion efficiency of the dye-sensitized type solar cells include the short-circuit current, open circuit voltage, dimensional factors, and the like, but regarding the short-circuit current and the dimensional factors among these, various improvements for increasing the conversion efficiency based on an expansion of the absorption wavelength region by designing the sensitizing dye to be used, and based on a reduction in the internal resistance of the cell, and the like, have been proposed. However, not much research has been made regarding the open circuit voltage, and thus little progress, if any, in its improvement has been made. Only in Patent Document 2, niobium oxide is used for the semiconductor electrode for the purpose of improving the open circuit voltage, but its effect is insufficient because the niobium oxide is a single metal oxide.

[Patent Document 1] Japanese Patent No. 2664194
[Patent Document 2] Japanese Patent No. 2945955
[Non-Patent Document 1] J. Am. Chem. Soc. 115 (1993) 6382

DISCLOSURE OF THE INVENTION

Problem to be solved by the Invention

It is the primary object of the present invention to provide metal oxide microparticles useful for the dye-sensitized solar cell, and a solar cell capable of exhibiting a high open circuit voltage using the same.

Means for Solving the Problem

As a result of having continued an intensive research to solve the above-described problem, the present

inventers found that a porous titanium type composite oxide microparticle (hereinafter, referred to as a modified titanium oxide microparticle) modified with a specific nontitanic metal oxide including silicon oxide can solve the above-described problem, and thus the present inventers have completed the present invention.

Namely, the present invention is pertinent to the following (1) to (15) :

(1) A modified titanium oxide microparticle comprising: titanium oxide and one or two or more nontitanic metal oxides, including silicon oxide, selected from the group consisting of oxides of elements of Group IB, Group IIA, Group IIB, Group IIIA, Group IIIB, Group IVA other than titanium. Group IVB, Group VIA and Group VIII of the periodic table and vanadium oxide.

(2) The modified titanium oxide microparticle according to (1), wherein the nontitanic metal oxide, including silicon oxide, is one or two members selected from the group consisting of magnesium oxide, calcium oxide, strontium oxide, zirconium oxide, tantalic oxide, chromic oxide, molybdic oxide, niobic oxide, scandium oxide, vanadium oxide, iron oxide, nickel oxide, tungsten oxide, zinc oxide, aluminum oxide, indium oxide, silicon oxide and tin oxide.

(3) The modified titanium oxide microparticle according to (1) or (2), wherein the titanium oxide is of anatase.

(4) The modified titanium oxide microparticle according to any one of (1) to (3), wherein a proportion of the titanium oxide to the nontitanic metal oxides other than titanium oxide but including silicon oxide, expressed by an atomic ratio of titanium/nontitanium metal atom including silicon atoms, ranges from 1/0.02 to 1/0.5.

(5) A method of manufacturing a modified titanium oxide microparticle comprising titanium oxide and nontitanic metal oxide including silicon oxide, comprising the step of reacting a titanium alkoxide with an alkoxide of one or two or more nontitanium metals, including silicon, selected from the group consisting of metals of Group IIA, Group IIB, Group IIIA, Group IIIB, Group IVA other than titanium, Group IVB and Group VA of the periodic table in an organic solvent.

(6) The method of manufacturing a modified titanium oxide microparticle according to (5), wherein the organic solvent is an alcohol solvent.

(7) The method of manufacturing a modified titanium oxide microparticle according to (6), wherein the alcohol solvent is a monohydric alcohol or a polyhydric alcohol.

(8) The method of manufacturing a modified titanium oxide microparticle according to (7), wherein the polyhydric alcohol is 1,4-butanediol.

(9) A dye-sensitized photoelectric conversion device comprising:

a first conductive support having a semiconductor-containing layer sensitized with a dye;
a second conductive support having a counter electrode disposed oppositely to the first conductive support at a predetermined interval; and
a charge transfer layer interposed in a gap between the first and second conductive supports,
wherein the semiconductor-containing layer contains the modified titanium oxide microparticle according to any one of (1) to (4).

(10) The dye-sensitized photoelectric conversion device according to (9), wherein a mean particle diameter of a primary particle of the modified titanium oxide microparticle ranges from 1 to 1000 nm.

(11) The dye-sensitized photoelectric conversion device according to (9) or (10), wherein the dye is a methine dye.

(12) The dye-sensitized photoelectric conversion device according to (9) or (10), wherein the dye is a combination of a methine dye and a metal complex dye.

(13) A dye-sensitized photoelectric conversion device comprising:

a first conductive support having a semiconductor-containing layer sensitized with a dye;
a second conductive support having a counter electrode disposed oppositely to the first conductive support at a predetermined interval; and
a charge transfer layer interposed in a gap between the first and second conductive supports,
wherein the semiconductor-containing layer contains a modified titanium oxide microparticle comprising titanium oxide and either niobic oxide or tantalic oxide obtained by the method according to any one of (5) to (8).

(14) The dye-sensitized photoelectric conversion device according to (13), wherein the dye is a methine dye.

(15) The dye-sensitized photoelectric conversion device according to (13), wherein the dye is a combination of a methine dye and a metal complex dye.

Advantages of the Invention

A solar cell using the modified titanium oxide microparticle of the present invention has a high open circuit

voltage. Accordingly, the above cell is useful as a power source for electric appliances, such as a calculator, which function only with a voltage greater than or equal to a specified value and with a minimum electric current. Moreover, because the voltage is high, the number of serial connected cells can be reduced, thus providing a merit that the manufacturing cost of the electric appliances and the like are reduced.
Moreover, because the modified titanium oxide microparticle of the present invention is excellent in photocatalyst ability, it is useful as a catalyst for oxidation reaction using light or is useful for semiconductor electrodes and the like.

DETAILED DESCRIPTION OF THE PREFERRED EMBODIMENT

Hereinafter, the present invention will be described in detail.
First, the modified titanium oxide microparticle of the present invention will be described.
The modified titanium oxide microparticle of the present invention may be called a titanium-based composite oxide microparticle, and feature the types of nontitanic metal oxides, including silicon oxide, compounded with titanium oxide, and the proportion of a nontitanic metal oxide, including silicon oxide, compounded with the titanium oxide, and further the compounding method, respectively.
As the type of the nontitanic metal oxide, including silicon oxide, compounded with the modified titanium oxide microparticle, one or two or more nontitanic metal oxides, including silicon oxide, selected from the group consisting of oxides of elements of Group IB, Group IIA, Group IIB, Group IIIA, Group IIIB, Group IVA other than titanium, Group IVB, Group VIA and Group VIII of the periodic table and vanadium oxide, are used. Preferable ones of the nontitanic metal oxide, including silicon oxide, include: for example, vanadium oxide, magnesium oxide, calcium oxide, and strontium oxide that are oxides of Group IIA elements of the periodic table; zinc oxide that is an oxide of Group IIB element; scandium oxide that is an oxide of Group IIIA element; aluminum oxide and indium oxide that are oxides of Group IIIB elements; zirconium oxide and hafnium oxide that are oxides of Group IVA elements; silicon oxide and tin oxide that are oxides of Group IVB elements; chromium oxide, molybdenum oxide and tungsten oxide that are oxides of Group VIA elements; iron oxide and nickel oxide that are oxides of Group VIII elements; and silver oxide that is an oxide of Group IB element. In particular, the oxides of magnesium, zirconium, and silicon are preferable, and one or two or more of these may be simultaneously used. Moreover, as the metal oxide, tantal oxide and niob oxide may be used.
In the modified titanium oxide microparticle of the present invention, proportion of the titanium oxide to the nontitanic metal oxides other than titanium oxide but including silicon oxide, expressed by an atomic ratio of titanium/nontitanium metal atom including silicon atoms, preferably ranges from 1/0.005 to 1/20, more preferably ranges from 1/0.01 to 1/3, and further more preferably ranges from 1/0.02 to 1/0.5.
In case of using the modified titanium oxide microparticle of the present invention for solar cells, a semiconductor-containing layer (described below) composed of the modified titanium oxide microparticles preferably has a large surface area for the purpose of adsorbing a sensitizing dye and the like. Moreover, it is preferable that the primary particle diameter of the modified titanium oxide microparticle of the present invention is small to achieve a large surface area. Specifically, the primary particle diameter is in the range of 1 to 3000 nm, and more preferably in the range of 5 to 500 nm. The primary particle diameter of the modified titanium oxide microparticle can be calculated from a specific surface area, and the specific surface area is usually in the range of 0.5 to 1500 $m^2/g$, preferably in the range of 3 to 300 $m^2/g$. Moreover, the fine pore volume of the modified titanium oxide microparticle is preferably in the range of 0.05 to 0.8 ml/g, and furthermore the average pore size is preferably in the range of 1 to 250 nm. Although the modified titanium oxide microparticle obtained by the manufacturing method described below can be usually obtained as a microparticle having the above-described physical properties, the physical properties of the microparticle also can be adjusted to within the above-described range by sifting them, as desired.
As the method of manufacturing the modified titanium oxide microparticle of the present invention, the modified titanium oxide microparticles can be also obtained by reacting, in a solvent within a reaction container, a titanium alkoxide and the alkoxide of each of the nontitanic metal oxides, including silicon oxide, other than titanium, the titanium alkoxide and the alkoxide serving as the raw materials of the modified titanium oxide microparticle. In addition, the modified titanium oxide microparticle of the present invention can be also obtained by reacting, in a solvent within a reaction container, a mixture composed of a titanium alkoxide and a salt of any one of chloride, sulfide, nitrate, acetate, and the like of the above metals other than titanium, but a method of using the alkoxide of a nontitanium metal including silicon is preferable. As the solvent to be used, organic solvents, such as alcohol, hexane, and toluene, and a. mixture of these can be used, for example. By using such solvent, a modified titanium oxide microparticle with high crystallinity can be obtained. In the case where the raw material is a metal alkoxide, it is especially preferable that the solvent is a monohydric alcohol or a polyhydric alcohol, and the polyhydric alcohol with a boiling point of 80°C or higher is more preferable, and 1,4-butanediol and octanol are especially preferable. Moreover, an organic solvent without an addition of water is preferable. Here, the "organic solvent without an addition of water" is an organic solvent under natural conditions. The organic solvent with a water content of 10% or less, 5% or less, and 3% or less are preferable in this order. The reaction temperature approximately in the range of 110°C to 400°C is preferable. The reaction may be carried out under nitrogen

substitution. Moreover, the desired microparticle may be obtained by operating a centrifugal separator or the like after completion of the reaction, or after completion of the reaction a valve attached to the reaction container is opened while keeping the temperature in the vicinity of the reaction temperature, and then with the internal pressure, solvents, such as alcohols used, are removed in an evaporated state under heating, as needed, and thereby it is also possible to obtain the microparticle.

Because the modified titanium oxide microparticle of the present invention is excellent in photocatalyst ability, it can be used as a catalyst used for a photooxidation reaction typified by Honda-Fujishima effect, or as a carrier or the like used for a catalyst using its heat-resisting property; however, a favorable application is the application as a semiconductor-containing layer (semiconductor electrode) in dye-sensitized photoelectric conversion devices. In other words, by using the modified titanium oxide microparticle of the present invention in photoelectric conversion devices, a significant effect is exhibited in an improvement in the open circuit voltage, and the like.

Hereinafter, a method of using the modified titanium oxide microparticle of the present invention in a solar cell, which is one of the favorable applications, will be described.

The modified titanium oxide microparticle of the present invention is made by devising the type and the proportion of titanium oxide and nontitanic metal oxide, including silicon oxide, compounded with the titanium oxide, and furthermore the compounding method, and such modified titanium oxide microparticle can increase the photocatalyst ability by being sensitized with, for example, a photocatalyst material of a high catalytic activity and with a specific sensitizing dye. In other words, in a dye-sensitized photoelectric conversion device comprising: a first electrically conductive support having a semiconductor-containing layer sensitized with a dye on the electrically conductive support, such as a conductive glass at least one side of which is transparent; a second electrically conductive support having a counter electrode, the second electrically conductive support being arranged oppositely to the first electrically conductive support at a predetermined interval; and a charge transfer layer being interposed in a gap between the first and second electrically conductive supports, the semiconductor-containing layer is formed using the modified titanium oxide microparticle and the modified titanium oxide microparticle is caused to adsorb a sensitizing dye, thereby allowing a photoelectric conversion device and a solar cell with the above-described features to be obtained. In addition, in the present invention, the one made by arranging lead wires to form a closed circuit so that electric current generated from the photoelectric conversion device can be taken out is called a solar cell.

In the present invention, as the electrically conductive support, for example, the one made by thin-filming a conductive substance typified by FTO (fluorine doped tin oxide), ATO (antimony doped tin oxide), and ITO (indium doped tin oxide) on the surface of a stable inorganic or organic substrate, such as glass, plastic, polymer film, titanium, tantalum, and carbon, is used. The conductivity thereof is usually 1000 $\Omega/cm^2$ or lower, preferably 100 $\Omega/cm^2$ or lower. The one made by providing a semiconductor-containing layer sensitized with a dye on the surface of the electrically conductive support is the semiconductor electrode. Hereinafter, the electrically conductive support will be simply referred to also as a conductive support. Such conductive support may be prepared by a method known per se, or can be also obtained from the market.

As the method of providing the semiconductor-containing layer on the conductive support, a method of drying, curing or calcining after applying or coating a slurry or a paste of the modified titanium oxide microparticle onto the conductive support, and the like is preferable. Other than this, a method of preparing a thin film composed of an oxide semiconductor directly on the substrate by vacuum evaporation, a method of electrically depositing using the substrate as an electrode, and the like can be employed. The method of using a slurry of the modified titanium oxide microparticle or the like is the most preferable in terms of the performance of the oxide semiconductor electrode. The slurry can be prepared from a suspension of the modified titanium oxide microparticle obtained by dispersing a secondarily condensed certain oxide semiconductor microparticle using a dispersant so that the average primary particle diameter may be in the range of 1 to 3000 nm in the dispersion medium, or by hydrolyzing an alkoxide, which is a precursor of an oxide semiconductor, using a hydrolysis reaction (glycothermal method) of alkoxide in alcohol, as in the present invention.

As the dispersion medium in order to obtain the slurry, any one capable of dispersing the modified titanium oxide microparticle may be used, and water, alcohol such as ethanol, acetone, ketone such as acetylacetone, and an organic solvent of hydrocarbons such as hexane, are used. These may be mixed and used, and a use of water is preferable in reducing a viscosity change of the slurry.

It is also possible to add a dispersion stabilizer or the like to the slurry for the purpose of obtaining the stable primary microparticle. Specific examples of the dispersion stabilizer to be used include a polyhydric alcohol such as polyethylene glycol, or a condensation product of such polyhydric alcohol and phenol, octyl alcohol, or the like, cellulose derivatives, such as hydroxypropyl methylcellulose, hydroxymethyl cellulose, hydroxyethyl cellulose, and carboxymethyl cellulose, poly acrylamide, poly(meth)acrylic acid, and its salt, a copolymer with acrylamide and (meth)acrylic acid or its alkali metal salt of poly(meth)acrylic acid and its salt, or a polyacrylic acid derivative, which is watersoluble and a copolymer of: (A) an alkali metal salt of acrylamide and/or (meth) acrylic acid; and (B) a hydrophobic monomer, such as methyl (meth)acrylate, (meth)acrylic ester such as ethyl (meth)acrylate, or styrene, ethylene, and propylene or the like, salts of a formaldehyde melaminesulfonate condensation product, salts of a naphthalenesulfonic acid formaldehyde

condensation product, high-molecular weight ligninsulfonic acid salt, acids such as hydrochloric acid, nitric acid and acetic acid, but not limited to these dispersion stabilizers. Moreover, these dispersion stabilizers may be not only used individually but also used in combination of two or more kinds thereof.

Among these, the condensation product with polyhydric alcohols, such as polyethylene glycol, or phenol, octyl alcohol, or the like, and the one having a carboxyl group, a sulfone group, and/or an amide group in the molecule are preferable, and poly(meth)acrylic acids and its salts, such as poly(meth)acrylic acid, sodium poly(meth)acrylate, potassium poly(meth)acrylate, lithium poly(meth)acrylate, carboxymethyl cellulose, and acids, such as hydrochloric acid, nitric acid, and acetic acid, are preferable.

The concentration of the modified titanium oxide microparticle in the slurry is usually in the range of 1 to 90 wt%, and preferably in the range of 5 to 80 wt%.

The calcination temperature of the conductive support coated with the slurry is generally less than or equal to a melting point (or softening temperature) of the substrate used, and is usually in the range of 100°C to 900°C, and preferably in the range of 100°C to 600°C. Moreover, the calcination time is not limited in particular but is preferably approximately 4 hours or less. The layer thickness after calcination is preferably in the range of about 1 to 100 μm, more preferably in the range of 3 to 50 μm, and particularly preferably in the range of 5 to 30 μm.

For the purpose of improving the surface smoothness of the semiconductor-containing layer thus obtained, a secondary treatment may be carried out (see non-Patent Document 1). For example, by directly dipping the whole conductive support having the semiconductor-containing layer into a solution of alkoxide, chloride, nitride, sulfide, or acetate of the same nontitanium metal, including silicon, as the metal of the nontitanic metal oxide, including silicon oxide, used in order to prepare the modified titanium oxide microparticle, and then drying or re-calcining the same, it is possible to improve the smoothness. As the metal alkoxide, titanium ethoxide, titanium isopropoxide, titanium t-butoxide, n-dibutyl-diacetyltin, and the like are listed, and an alcoholic solution thereof is used. In case of chloride, for example, titanium tetrachloride, tin tetrachloride, zinc chloride, and the like are listed, and an aqueous solution thereof or the like is suitably used.

The sensitizing dye adsorbed (carried) to the modified titanium oxide microparticle of the present invention allows light energy to be efficiently absorbed and thus be converted into electric energy.

As the sensitizing dye, a metal complex dye, a nonmetallic organic dye, and the like are used, but not limited in particular as long as it sensitizes the light absorption conjointly with the modified titanium oxide microparticles, and one type of dye may be used or several types of dyes may be mixed and used. Moreover, in mixing, organic dyes may be mixed or an organic dye and a metal complex dye may be mixed. In particular, by mixing dyes having different absorption wavelengths, a broad absorption wavelength can be used to obtain a dye-sensitized photoelectric conversion device and a solar cell with a high conversion efficiency. The metal complex dyes to be used include, for example, a ruthenium complex, a phthalocyanine, a porphyrin, and the like, and likewise, the organic dyes include methine dyes, such as nonmetallic phthalocyanine, porphyrin and cyanine, merocyanine, oxonol, triphenylmethane dyes, and an acrylic acid dye, and dyes such as xanthene dyes, azo dyes, anthraquinone dyes and perylene dyes. Preferably, the ruthenium complex, merocyanine, and the methine dyes such as the above-described acrylic acid based ones can be enumerated. As the preferable ones, the compounds described in the followings are listed: WO 2002/011213, WO 2002/071530, JP 2002-334729 A, JP 2003-007358 A, JP 2003-017146 A, JP 2003-086257 A, JP 2003-059547 A, JP 2003-115333 A, JP 2003-132965 A, JP 2003-142172 A, JP 2003-151649 A, JP 2003-157915 A, JP 2003-282165 A, JP 2004-014175 A, JP 2004-022222 A, Japanese Patent Application No. 2004-320699, Japanese Patent Application No. 2005-111696, Japanese Patent Application No. 2005-151422, Japanese Patent Application No. 2005-173429, Japanese Patent Application No. 2005-177087, and the like. Particularly preferable ones among these include dyes of the following general formula (1), for example. In addition, each substituent in the general formula (1) is shown in Table 1.

[Formula 1]

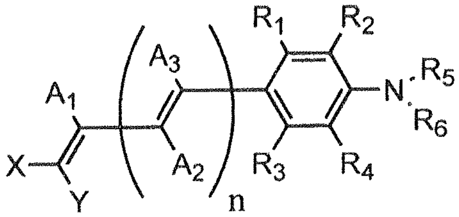

(1)

[Table 1]

Table 1

| Compound No. | n | X | Y | A1 | A2 | A3 | R1 | R2 | R3 | R4 | R5 | R6 |
|---|---|---|---|---|---|---|---|---|---|---|---|---|
| 1 | 0 | COOH | H | H | - | - | H | H | H | H | CH3 | CH3 |
| 2 | 0 | COOH | CN | H | - | - | H | H | H | H | Ph | Ph |
| 3 | 0 | COOH | CN | CH3 | - | - | H | H | H | H | Ph | Ph |
| 4 | 0 | COOH | COCF3 | H | - | - | H | H | H | H | Ph | Ph |
| 5 | 0 | COOH | COCH3 | H | - | - | H | H | H | H | C2H5 | C2H5 |
| 6 | 0 | COOH | COOH | H | - | - | H | H | H | H | C4H9 | C4H9 |
| 7 | 0 | COOH | CN | H | - | - | H | H | H | H | C4H9 | C4H9 |
| 8 | 0 | COOH | CN | H | - | - | H | H | H | H | C8H17 | C8H17 |
| 9 | 0 | COOH | CN | H | - | - | H | H | H | H | C18H37 | C18H37 |
| 10 | 0 | COOH | CN | H | - | - | H | H | H | H | CH(CH3)2 | CH(CH3)2 |
| 11 | 0 | PO(OH)2 | CN | H | - | - | H | H | H | H | Ph | Ph |
| 12 | 0 | PO(OH)2 | PO(OH)2 | H | - | - | H | H | H | H | Ph | Ph |
| 13 | 0 | COOLi | CN | H | - | - | H | H | H | H | Ph | Ph |
| 14 | 0 | COONa | CN | H | - | - | H | H | H | H | Ph | Ph |
| 15 | 0 | COOK | CN | H | - | - | H | H | H | H | Ph | Ph |
| 16 | 0 | COOH | CN | H | - | - | OH | H | H | H | Ph | Ph |
| 17 | 0 | COOH | CN | H | - | - | OCH3 | H | H | H | Ph | Ph |
| 18 | 0 | COOH | CN | H | - | - | OCH3 | H | H | CH3 | Ph | Ph |
| 19 | 1 | COOH | CN | H | H | H | H | H | H | H | Ph | Ph |
| 20 | 1 | COOH | CN | H | H | H | Cl | Cl | Cl | Cl | Ph | Ph |
| 21 | 1 | COOH | CN | CH3 | CH3 | CH3 | H | H | H | H | Ph | Ph |
| 22 | 1 | COOH | CN | H | H | H | NHCOCH3 | H | H | OCH3 | C2H5 | C2H5 |
| 23 | 2 | COOH | CN | H | H | H | H | H | H | H | Ph | Ph |
| 24 | 3 | COOH | CN | H | H | H | H | H | H | H | Ph | Ph |
| 25 | 4 | COOH | CN | H | H | H | H | H | H | H | Ph | Ph |

(continued)

| Compound No. | n | X | Y | A1 | A2 | A3 | R1 | R2 | R3 | R4 | R5 | R6 |
|---|---|---|---|---|---|---|---|---|---|---|---|---|
| 26 | 5 | COOH | CN | H | H | H | H | H | H | H | Ph | Ph |
| 27 | 6 | COOH | CN | H | H | H | H | H | H | H | Ph | Ph |
| 28 | 7 | COOH | CN | H | H | H | H | H | H | H | Ph | Ph |

The other specific examples include the following dyes.

[Formula 2]

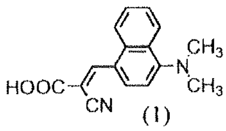
(1)

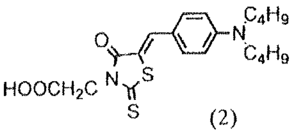
(2)

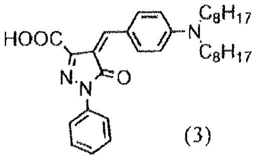
(3)

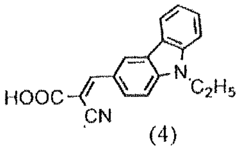
(4)

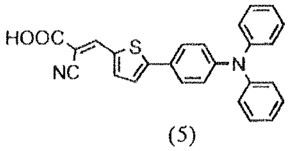
(5)

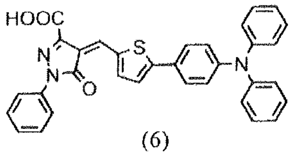
(6)

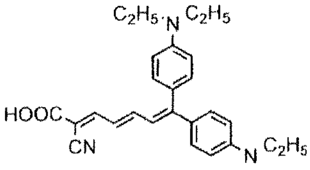
(7)

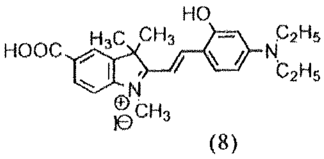
(8)

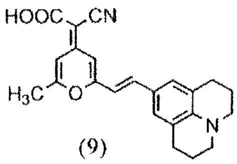
(9)

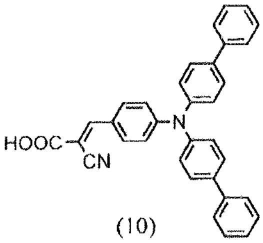
(10)

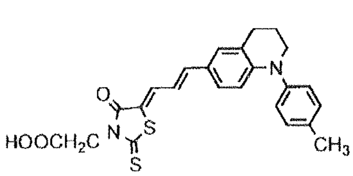
(11)

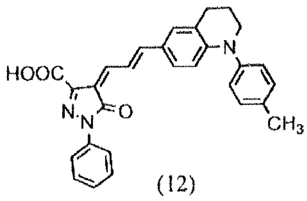
(12)

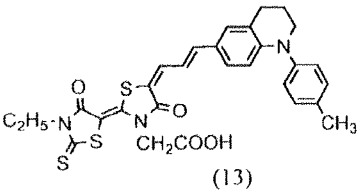
(13)

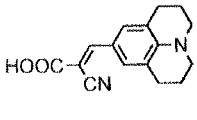
(14)

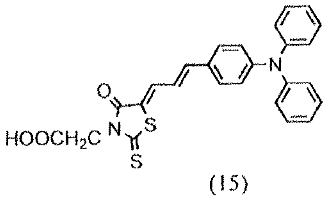
(15)

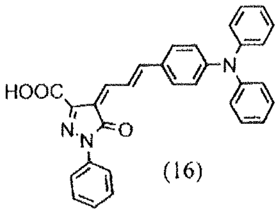
(16)

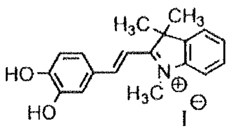
(17)

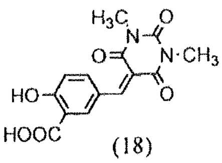
(18)

When the dyes are mixed and used, the ratio between the dyes is not critical. The optimum condition can be chosen depending on the dyes used. An equimolar mixture or a mixture containing 10% by mole or more of each dye is generally preferable. When adsorbing dyes onto the semiconductor-containing layer using a solution in which two or more dyes are dissolved or dispersed, the concentration of the total of the two or more dyes in the solution may be the same as in a solution containing only one dye. As the solvent for dyes used in combination, solvents described below can be used and the solvent for each dye used may be the same or different.

The methods of allowing a support to carry a dye include a method of dipping the above-described modified titanium oxide microparticle or the conductive support, in which a semiconductor-containing layer composed of the modified titanium oxide microparticle is provided, into a solution obtained by dissolving each dye into the following solvents, or into a dispersion liquid obtained by dispersing a dye in case of the dye having a low salubility. The method of dipping the semiconductor-containing layer prepared on the conductive support into a dye solution is preferable. The dipping temperature is generally in the range of normal temperature to the boiling point of a solvent, and the dipping time is in the range of about one hour to 48 hours. Solvents to be used for dissolving the dye include, for example, methanol, ethanol, acetonitrile, dimethylsulfoxide, dimethylformamide, t-butanol, and the like. As for the dye concentration of the solution, a range of $1 \times 10^{-6}$ M to 1 M is usually suitable and a range of $1 \times 10^{-5}$ M to $1 \times 10^{-1}$ M is preferable. In case of the photoelectric conversion device, the conductive support, in which a semiconductor-containing layer thus sensitized with a dye is disposed, functions as the semiconductor electrode.

When dyes are supported on the semiconductor-containing layer, it is effective to allow the layer to carry the dyes under the co-presence of a clathrate compound in order to prevent the association of the dyes. Here, the clathrate compounds include a steroid type compound such as cholic acid and the like, crown ether, cyclodextrin, calyx allene, polyethylene oxide, or the like, but preferable ones include cholic acids, such as cholic acid, deoxycholic acid, chenodeoxycholic acid, cholic acid methyl ester, and sodium cholate and the like, and polyethylene oxide and the like. Moreover, the surface of the semiconductor electrode may be treated with an amine compound, such as 4-t-butyl pyridine, after the dye is carried. As the treatment method, a method of dipping the substrate, on which a semiconductor-containing layer carrying a dye has been provided, into an ethanol solution of an amine, and the like is employed.

The photoelectric conversion device of the present invention comprises a semiconductor electrode obtained by allowing the above-described semiconductor-containing layer to carry a sensitizing dye, a counter electrode provided so as to face thereto, and a charge transfer layer provided in between the both electrodes, as the principal elements.

As the charge transfer layer, a solution made by dissolving a redox electrolyte, a hole transporting material, and the like into a solvent or an ordinary temperature molten salt (ionic liquid) is used.

The redox electrolyte to be used includes, for example, a halogen redox electrolyte composed of a halogen molecule and a halogenated compound to which a halogen ion can be a counter ion; a metal redox electrolyte of a metal complex or the like, such as a ferrocyanic: acid salt-ferricyanic acid salt, ferrocene ferricinium ion, and a cobalt complex; an organic redox electrolyte of alkyl thiol-alkyl disulfide, a viologen dye, and hydroquinone-quinone and the like; but the halogen redox electrolyte is preferable. The halogen molecules in the halogen redox electrolyte composed of a halogen molecule-halogenated compound include, for example, an iodine molecule, a bromine molecule, and the like, and the iodine molecule is preferable. Moreover, the halogenated compounds to which a halogen ion can be a counter ion include, for example, halogenation metal salts of LiI, NaI, KI, CsI, $CaI_2$, CuI or the like, or organic quaternary ammonium salts of halogen, such as tetraalkylammonium iodide, imidazolium iodide, 1-methyl-3-alkylimidazolium iodide, and pyridinium iodide, and the like, but the salts to which an iodine ion can be a counter ion are preferable. The salts to which an iodine ion can be a counter ion include, for example, a lithium iodide, a sodium iodide, an iodination trimethylammonium salt, and the like.

Moreover, when the charge transfer layer is formed in a form of solution, as its solvent an electrochemically inert one is used. For example, acetonitrile, propylene carbonate, ethylene carbonate, 3-methoxypropionitrile, methoxyacetonitrile, ethylene glycol, propylene glycol, diethylene glycol, triethylene glycol, dimethoxyethane, diethyl carbonate, diethylether, diethyl carbonate, dimethyl carbonate, 1,2-dimethoxyethane, dimethylformamide, dimethylsulfoxide, 1,3-dioxolane, methyl formate, 2-methyl tetrahydrofuran, 3-methoxy-oxaziridine-2-on, γ-butyrolactone, sulfolane, tetrahydrofuran, water, and the like can be included in preferable examples. Among these, in particular, acetonitrile, propylene carbonate, ethylene carbonate, 3-methoxypropionitrile, methoxyacetonitrile, ethylene glycol, 3-methoxy oxaziridine-2-on, γ-butyrolactone, and the like are particularly preferable. These may be used individually or in admixture of two or more members thereof. The concentration of the redox electrolyte is usually in the range of 0.01 to 99% by weight, preferably in the range from 0.1 to 90% by weight.

Moreover, in preparing the charge transfer layer, a method of using a room-temperature molten liquid (ionic liquid) as the solvent for the redox electrolyte can be also employed. The room-temperature molten liquids to be used include, for example, 1-methyl-3-alkyl imidazolium iodide, vinyl imidazolium tetrafluoride, 1-ethylimidazole sulfonate, alkyl imidazolium trifluoromethane sulfonylamide, 1-methyl pyrrolidinium iodide, 1-methyl-3-alkyl imidazolium bis(trifluoromethane sulfonyl)amide, and the like. Moreover, for the purpose of improving the durability of the photoelectric conversion device, it is also possible to dissolve a low-molecular gelatinizer into the charge transfer layer and thereby thicken, or to simultaneously use a reactant component and then allow the same to react after injecting the charge transfer layer, thereby turning into a gel electrolyte.

On the other hand, in the photoelectric conversion device of the present invention, a hole transport material and a p-type semiconductor in place of the redox electrolyte can be also used as the solid type. The hole transport materials to be used include, for example, conductive polymers, such as an amine derivative, polyacetylene, poly aniline, and polythiophene, and a discotic liquid crystal, and the like. Moreover, the p-type semiconductor includes CuI, CuSCN, and

the like, for example.

As the counter electrode in the photoelectric conversion device of the present invention, the ones known per se, such as the ones made by vapor-depositing platinum, carbon, rhodium, ruthenium, or the like, which catalytically act on the reduction reaction of the redox electrolyte on the surface of the conductive support, such as FTO conductive glass, or the ones made by coating and calcining a precursor of the conductive microparticle on the surface of the conductive support, are used. The film thickness of platinum, carbon, rhodium, and ruthenium after coating and calcining is preferably in the range of 10 to 500Å.

The dye sensitizing device of the present invention comprises: a semiconductor electrode, in which a semiconductor-containing layer sensitized with a dye is disposed on the surface of a conductive support; a counter electrode disposed oppositely to the semiconductor electrode at a predetermined interval, the periphery thereof being sealed with a sealant; and a charge transfer layer being sealed in the gap therebetween. As the method of manufacturing the same, for example, a semiconductor-containing layer sensitized with a dye is disposed to serve as the semiconductor electrode, considering a sealing portion in the periphery of one conductive support. Next, for example, after adding a spacer, such as a glass fiber, to an ultraviolet curing sealant used for the photoelectric conversion device, the sealant is applied by screen printing or by means of a dispenser while leaving an injection port of the charge transfer layer in the periphery of this semiconductor electrode, and thereafter, the solvent is evaporated by heating at 100°C for 10 minutes, for example, and the one made by providing platinum or the like onto the other conductive support is overlapped so that the conductive surfaces thereof may face to each other, and after a gap uniformizing process is carried out by pressing, the above overlapped ones are irradiated with an UV light using a high pressure mercury vapor lamp, e.g., at 3000 $mJ/cm^2$, for curing. As required, a post curing can be carried out at 120°C for 10 minutes, for example.

After injecting the charge transfer layer into the gap between both conductive supports, the injection port of the charge transfer layer is sealed with a sealant, thereby allowing a photoelectric conversion device to be obtained. In addition, in the above, the sealant is prepared using an epoxy resin, an epoxy (meth)acrylate resin, a crosslinking agent, a polymerization initiator, or the like as the main components. Alternatively, the sealant is prepared using a polyisobutylene-based resin as the main component. As for these, the commercially available products can be used as it is, respectively. The photoelectric conversion device of the present invention obtained in this way is excellent in durability, such as adhesiveness and a resistance to wet heat, and a dye-sensitized solar cell can be obtained by arranging lead wires on the positive electrode and negative electrode and then inserting a resistance component therebetween.

Fig. 1 (a first drawing) is a principal-part cross sectional view explaining the structure of a dye-sensitized solar cell using a photoelectric conversion device prepared from the modified titanium oxide microparticle according to the present invention, where reference numeral 1 represents a conductive substance, reference numeral 2 represents a semiconductor-containing layer sensitized with a dye, respectively. Reference numerals 1 and 2 combined are referred to as semiconductor electrodes. Moreover, reference numeral 3 represents a counter electrode in which platinum or the like is provided on an inner side conductive surface of a substrate, reference numeral 4 represents a charge transfer layer disposed as to be sandwiched by the opposing conductive supports, and reference numeral 5 represents a sealant, and reference numeral 6 represents a substrate, respectively. Reference numerals 1 and 6 combined are referred to as conductive supports.

## Examples

Hereinafter, the present invention will be described in more detail with reference to Examples.

### Example 1

With the use of 7.32 g of titanium isopropoxide as a titanium alkoxide and 24.23 g of zirconium isopropoxide as a zirconium alkoxide, the mixture of them (Ti/Zr atomic ratio = 1/3) was suspended in 130 ml of 1,4-butanediol as a solvent, and was put in an autoclave of 300 ml capacity and sealed. The interior of the autoclave was substituted with nitrogen and thereafter was raised to 300°C to carry out heat treatment for 2 hours. After completion of the reaction, a valve of the autoclave was opened to remove the solvent, while keeping at 300°C, thereby recovering a reaction product as a xerogel and obtaining 11.4 g of modified titanium oxide microparticle.

### Example 2

With the use of 25 g of titanium isopropoxide as a titanium alkoxide and 18.2 g of zirconium isopropoxide as a zirconium alkoxide, the mixture of them (Ti/Zr atomic ratio = 1/0.3) was suspended in 130 ml of 1, 4-butanediol as a solvent, and was put in an autoclave of 300 ml capacity and sealed. The interior of the autoclave was substituted with nitrogen and thereafter was raised to 300°C to carry out heat treatment for 2 hours. After completion of the reaction, the autoclave was allowed to cool to obtain 150 ml of a suspension containing 13.7 g of modified titanium oxide microparticle.

Example 3

With the use of 25 g of titanium isopropoxide as titanium alkoxide and 25 g of zirconium isopropoxide as a zirconium alkoxide, the mixture of them (Ti/Zr atomic ratio = 1/1) was suspended in 260 ml of 1,4-butanediol as a solvent, and was put in an autoclave of 300 ml capacity and sealed. The interior of the autoclave was substituted with nitrogen and thereafter was raised to 300°C to carry out heat treatment for 2 hours. After completion of the reaction, the autoclave was allowed to cool to obtain 300 ml of a suspension containing 16.3 g of modified titanium oxide microparticle.

Example 4

Titanium isopropoxide and tetraethyl orthosilicate were used in an atomic ratio as shown in Table 2, and 150 ml of a suspension containing 11.1 g of modified titanium oxide microparticle was obtained in the same manner as in Example 2.

Example 5

Titanium isopropoxide and tetraethyl orthosilicate were used in an atomic ratio as shown in Table 2, and 150 ml of a suspension containing 11.1 g of modified titanium oxide microparticle was obtained in the same manner as in Example 2.

Example 6

Titanium isopropoxide and aluminium tetraisopropoxide were used in an atomic ratio as shown in Table 2, and 150 ml of a suspension containing 11.0 g of modified titanium oxide microparticle was obtained in the same manner as in Example 2.

Example 7

Titanium isopropoxide, ethyl orthosilicate, and zirconium isopropoxide were used in an atomic ratio as shown in Table 2, and 150 ml of a suspension containing 14.2 g of modified titanium oxide microparticle was obtained in the same manner as in Example 2.

Example 8

With the use of 25 g of titanium isopropoxide as a titanium alkoxide and 1.82 g of zirconium isopropoxide as a zirconium alkoxide, the mixture of them (Ti/Zr atomic ratio = 1/0.03) was suspended in 130 ml of 1,4-butanediol as a solvent, and was put in an autoclave of 300 ml capacity and sealed. The interior of the autoclave was substituted with nitrogen and thereafter was raised to 300°C to carry out heat treatment for 2 hours. After completion of the reaction, the autoclave was allowed to cool to obtain 150 ml of a suspension containing 7.5 g of modified titanium oxide microparticle.

Example 9

Titanium isopropoxide and zirconium isopropoxide were used in an atomic ratio as shown in Table 2, and 150 ml of a suspension containing 8.5 g of modified titanium oxide microparticle was obtained in the same manner as in Example 8.

Example 1.0

Titanium isopropoxide and zirconium isopropoxide were used in an atomic ratio as shown in Table 2, and the mixture of them was suspended in 130 ml of toluene as a solvent, while setting the other conditions similar to those in Example 8, and 150 ml of a suspension containing 13.1 g of modified titanium oxide microparticle was obtained.

Example 11

Titanium isopropoxide and tetraethyl orthosilicate were used in an atomic ratio as shown in Table 2, and 150 ml of a suspension containing 8.1 g of modified titanium oxide microparticle was obtained in the same manner as in Example 8.

Example 12

Titanium isopropoxide and tetraethyl orthosilicate were used in an atomic ratio as shown in Table 2, and 150 ml of a suspension containing 8.1 g of modified titanium oxide microparticle was obtained in the same manner as in Example 8.

Example 13

Titanium isopropoxide and tetraethyl orthosilicate were used in an atomic ratio as shown in Table 2, and 150 ml of a suspension containing 10.3 g of modified titanium oxide microparticle was obtained in the same manner as in Example 8.

Example 14

Titanium isopropoxide and tetraethyl orthosilicate were used in an atomic ratio as shown in Table 2, and 150 ml of a suspension containing 1.7.1 g of modified titanium oxide microparticle was obtained in the same manner as in Example 8.

Example 15

Titanium isopropoxide and aluminium tetraisopropoxide were used in an atomic ratio as shown in Table 2, and the mixture of them was suspended in 130 ml of hexane as a solvent, while setting the other conditions similar to those in Example 8, and 150 ml of a suspension containing 8.2 g of modified titanium oxide microparticle was obtained.

Example 16

Titanium isopropoxide and aluminium tetraisopropoxide were used in an atomic ratio as shown in Table 2, and 150 ml of a suspension containing 10.5 g of modified titanium oxide microparticle was obtained in the same manner as in Example 8.

Example 17

Titanium isopropoxide and aluminium tetraisopropoxide were used in an atomic ratio as shown in Table 2, and 150 ml of a suspension containing 17.5 g of modified titanium oxide microparticle was obtained in the same manner as in Example 8.

Example 18

Titanium isopropoxide, tetraethyl orthosilicate, and zirconium isopropoxide were used in an atomic ratio as shown in Table 2, and the mixture of them was suspended in 130 ml of n-octanol as a solvent, while setting the other conditions similar to those in Example 8, and 150 ml of a suspension containing 14.2 g of modified titanium oxide microparticle was obtained.

Example 19

Titanium isopropoxide, tetraethyl orthosilicate, and zirconium isopropoxide were used in an atomic ratio as shown in Table 2, and 150 ml of a suspension containing 16.5 g of modified titanium oxide microparticle was obtained in the same manner as in Example 8.

Example 20

Titanium isopropoxide and niobium butoxide were used in an atomic ratio as shown in Table 2, and 150 ml of a suspension containing 7.6 g of modified titanium oxide microparticle was obtained in the same manner as in Example 8.

Example 21

Titanium isopropoxide and niobium butoxide were used in an atomic ratio as shown in Table 2, and 150 ml of a suspension containing 8.8 g of modified titanium oxide microparticle was obtained in the same manner as in Example 8.

Example 22

Titanium isopropoxide and niobium butoxide were used in an atomic ratio as shown in Table 2, and 150 ml of a suspension containing 14.6 g of modified titanium oxide microparticle was obtained in the same manner as in Example 8.

Example 23

Titanium isopropoxide and magnesium acetate tetrahydrate were used in an atomic ratio as shown in Table 2, and the mixture of them was suspended in 130 ml of n-octanol as a solvent, while setting the other conditions similar to those in Example 8, and 150 ml of a suspension containing 7.7 g of modified titanium oxide microparticle was obtained.

Example 24

Titanium isopropoxide and magnesium acetate tetrahydrate were used in an atomic ratio as shown in Table 2, and 150 ml of a suspension containing 9.3 g of modified titanium oxide microparticle was obtained in the same manner as in Example 8.

Example 25

Titanium isopropoxide and magnesium acetate tetrahydrate were used in an atomic ratio as shown in Table 2, and 150 ml of a suspension containing 15.7 g of modified titanium oxide microparticle was obtained in the same manner as in Example 8.

Example 26

Titanium isopropoxide and strontium isopropoxide were used in an atomic ratio as shown in Table 2, and 150 ml of a suspension containing 9.6 g of modified titanium oxide microparticle was obtained in the same manner as in Example 8.

Example 27

Titanium isopropoxide and indium isopropoxide were used in an atomic ratio as shown in Table 2, and 150 ml of a suspension containing 9.8 g of modified titanium oxide microparticle was obtained an in the same manner as in Example 8.

Example 28

Titanium isopropoxide and tungsten isopropoxide were used in an atomic ratio as shown in Table 2, and 150 ml of a suspension containing 9.5 g of modified titanium oxide microparticle was obtained in the same manner as in Example 8.

Example 29

Titanium isopropoxide and zinc isopropoxide were used in an atomic ratio as shown in Table 2, and 150 ml of a suspension containing 9.6 g of modified titanium oxide microparticle was obtained in the same manner as in Example 8.

Comparative Example 1

Titanium isopropoxide was used to obtain 150 ml of a suspension containing 7.0 g of titanium oxide microparticles in the same manner as in Example 8.

Test 1

For the respective modified titanium oxide microparticle of the present invention obtained in each of the above-described Examples 1 to 29, the specific surface area was measured, the particle diameter (r) was calculated from the equation below and the results are summarized, in Table 2.

Equation: Specific surface area = $(2 \times 4\pi r^2)/(r^3 \times \text{true specific gravity})$

In addition, the true specific gravity was calculated using the true specific gravity value 4.15 of titanium oxide (anatase). Moreover, the measurement of the specific surface area was carried out using Gemini 2735 (Trade Name, Automatic Specific Surface Area. Measuring Apparatus manufactured by Shimadzu Corp.) after drying each suspension obtained above and calcining at 450°C for 30 minutes.

[Table 2]

| Table 2 Modified titanium oxide particle | | | | |
|---|---|---|---|---|
| Examples | Ti/Metal ratio | Reaction Temperature (°C) | BET Surface area (m2/g) | Particle diameter (nm) |
| Example 1 | Ti/Zr=1/3 | 300 | 70 | 20.6 |
| Example 2 | Ti/Zr=1/0.3 | 300 | 130 | 11.1 |
| Example 3 | Ti/Zr=1/1 | 300 | 100 | 14.4 |
| Example 4 | Ti/Si=1/0.06 | 300 | 130 | 11.1 |
| Example 5 | Ti/Si=1/0.06 | 250 | 150 | 9.6 |
| Example 6 | Ti/Al=1/0.06 | 300 | 120 | 12.0 |
| Example 7 | Ti/Si/Zr=1/0.06/0.3 | 300 | 170 | 8.5 |
| Example 8 | Ti/Zr=1/0.03 | 300 | 120 | 12.0 |
| Example 9 | Ti/Zr=1/0.1 | 300 | 105 | 13.8 |
| Example 10 | Ti/Zr=1/0.4 | 300 | 130 | 11.1 |
| Example 11 | Ti/Si=1/0.03 | 300 | 130 | 11.1 |
| Example 12 | Ti/Si=1/0.03 | 250 | 150 | 9.6 |
| Example 13 | Ti/Si=1/0.1 | 300 | 165 | 8.8 |
| Example 14 | Ti/Si=1/0.4 | 300 | 155 | 9.3 |
| Example 15 | Ti/Al=1/0.03 | 300 | 120 | 12.0 |
| Example 16 | Ti/Al=1./0.1 | 300 | 135 | 10.7 |
| Example 17 | Ti/Al=1/0.4 | 300 | 130 | 11.1 |
| Example 18 | Ti/Si/Zr=1/0.03/0.1 | 300 | 170 | 8.5 |
| Example 19 | Ti/Si/Zr=1/0.03/0.4 | 300 | 160 | 9.0 |
| Example 20 | Ti/Nb=1/0.03 | 300 | 150 | 9.6 |
| Example 21 | Ti/Nb=1/0.1 | 300 | 145 | 10.0 |
| Example 22 | Ti/Nb=1/0.4 | 300 | 110 | 13. 1 |
| Example 23 | Ti/Mg=1/0.03 | 300 | 85 | 17.0 |
| Example 24 | Ti/Mg=1/0.1 | 300 | 80 | 18.0 |
| Example 25 | Ti/Mg=1/0.4 | 300 | 105 | 13.8 |
| Example 26 | Ti/St=1/0.1 | 300 | 95 | 15.2 |
| Example 27 | Ti/In=1/0.1 | 300 | 105 | 13.8 |
| Example 28 | Ti/W=1/0.1 | 300 | 125 | 11.6 |
| Example 29 | Ti/Zn=1/0.1 | 300 | 110 | 13.1 |
| Comparative Example 1 | Ti | 230 | 45 | 32.1 |

Examples 30 to 70

As shown in the exampl.e (Fig. 1) of the photoelectric conversion device, a paste prepared by processing each of the modified titanium oxide microparticles obtained in Examples 1 to 7 with terpineol was applied onto a conductive

substance FTO (1) of a conductive glass support (glass = substrate 6), which is a conductive support of the dye-sensitized solar cell. The paste-applied substance was calcined at 450°C for 30 minutes. Thereafter, the calcined substirate was dipped in a $3 \times 10^{-4}$ M ethanol solution prepared by mixing any one or two of the following dye (1), dye (2) and dye (3), for 24 hours, thereby preparing a semiconductor electrode (2) sensitized with the dyes.

[Formula 3]

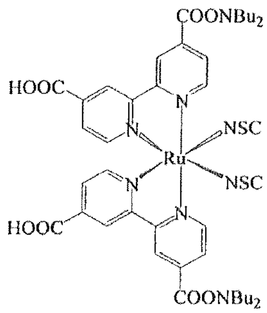

(1)

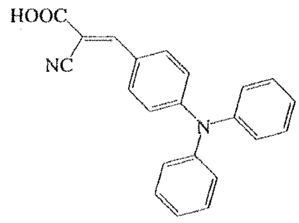

(2)

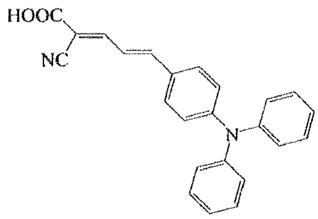

(3)

Next, in the similar manner, Pt was vapor-deposited to 200Å thickness on the conductive substance FTO of the conductive glass support to thereby prepare a counter electrode (3). The semiconductor electrode (2) sensitized with the dyes and the counter electrode (3) were bonded together by sealant (5). Then, from the injection port (not illustrated) of charge transfer layer (4) between two electrodes, an iodine-based charge transfer layer 4a (iodine/lithium iodide/methyl hexyl imidazolium iodide (manufactured by Shikoku Chemicals)/t-butyl pyridine were adjusted in 3-methoxy proxy nitrile so as to be 0.1M/0.1M/0.6M/1M, respectively) was packed into a cell. Thereafter, the cell was sealed with an ultraviolet curing sealant from the injection port, and then the ultraviolet curing sealant was irradiated with an ultraviolet ray for curing, thereby obtaining photoelectric conversion device of the present invention, respectively.

Table 3 below shows the modified titanium oxide microparticles and the dye(s) used in each Example, the film thickness after calcining the modified titanium oxide microparticle layer, and the used charge transfer layer, respectively. In addition, in Table 3, the charge transfer layer 4b was adjusted by ethylene carbonate/acetonitrile (6/4) so that iodine/tetra-n-propylammonium iodide should be 0.05M/0.5M, respectively.

Experimental Example: Performance test of the dye-sensitized solar cell using the photoelectric conversion device of the present invention

For each of the photoelectric conversion devices obtained in Examples 30 to 70, the active portion of the photoelectric conversion device to be measured was set to $0.5 \times 0.5$ $cm^2$. By using a 1 kW xenon lamp (manufactured by WACOM ELECTRIC CO., LTD.) as a light source, a dye-sensitized solar cell with 100 $mW/cm^2$ was obtained through an AM (airmass) filter-1.5. Each solar cell was connected to a solar simulator (manufactured by WATANABE MANUFACTURING CO., LTD.) to measure the open circuit voltage (V). The test results of the open-circuit voltage (V) are summarized in Table 3.

[Table 3]

| Table 3 Measurement results of open circuit voltage (V) | | | | | |
|---|---|---|---|---|---|
| Examples | Modified titanium oxide microparticle used | Film thickness (μm) | dye | Charge transport layer | Open circuit voltage (V) |
| Example 30 | (Example 1) | 10 | dye (1) | Charge transport layer 4a | 0.80 |
| Example 31 | (Example 2) | 6 | dye (3) | Charge transport layer 4b | 1.10 |
| Example 32 | (Example 2) | 12 | dye (3) | Charge transport layer 4b | 1.03 |
| Example 33 | (Example 2) | 18 | dye (3) | Charge transport layer 4b | 0.93 |
| Example 34 | (Example 2) | 11 | dye (1,3) | Charge transport layer 4a | 0.85 |
| Example 35 | (Example 3) | 10 | dye (3) | Charge transport layer 4b | 0.81 |
| Example 36 | (Example 4) | 11 | dye (1) | Charge transport layer 4a | 0.80 |
| Example 37 | (Example 5) | 10 | dye (1) | Charge transport layer 4a | 0.71 |
| Example 38 | (Example 6) | 10 | dye (2) | Charge transport layer 4a | 1.12 |
| Example 39 | (Example 7) | 11 | dye (3) | Charge transport layer 4b | 1.05 |
| Example 40 | (Example 7) | 13 | dye (1,3) | Charge transport layer 4a | 0.95 |
| Example 41 | (Example 8) | 13 | dye (1) | Charge transport layer 4a | 0.75 |
| Example 42 | (Example 9) | 6 | dye (3) | Charge transport layer 4b | 0.80 |
| Example 43 | (Example 9) | 12 | dye (3) | Charge transport layer 4b | 1.02 |
| Example 44 | (Example 9) | 18 | dye (3) | Charge transport layer 4b | 0.98 |
| Example 45 | (Example 9) | 10 | dye (1,3) | Charge transport layer 4a | 0.95 |
| Example 46 | (Example 10) | 10 | dye (2) | Charge transport layer 4b | 0.88 |
| Example 47 | (Example 10) | 13 | dye (3) | Charge transport layer 4b | 0.93 |
| Example 48 | (Example 11) | 11 | dye (1) | Charge transport layer 4a | 0.81 |
| Example 49 | (Example 12) | 10 | dye (1) | Charge transport layer 4a | 0.77 |
| Example 50 | (Example 13) | 12 | dye (1) | Charge transport layer 4a | 0.75 |
| Example 51 | (Example 14) | 13 | dye (1) | Charge transport layer 4a | 0.73 |
| Example 52 | (Example 15) | 10 | dye (3) | Charge transport layer 4b | 0.75 |
| Example 53 | (Example 16) | 12 | dye (3) | Charge transport layer 4b | 0.71 |

(continued)

| Table 3 Measurement results of open circuit voltage (V) | | | | | |
|---|---|---|---|---|---|
| Examples | Modified titanium oxide microparticle used | Film thickness (μm) | dye | Charge transport layer | Open circuit voltage (V) |
| Example 54 | (Example 17) | 12 | dye (3) | Charge transport layer 4b | 0.72 |
| Example 55 | (Example 18) | 11 | dye (2) | Charge transport layer 4b | 0.80 |
| Example 56 | (Example 19) | 10 | dye (2) | Charge transport layer 4b | 0.75 |
| Example 57 | (Example 20) | 10 | dye (3) | Charge transport layer 4b | 0.78 |
| Example 58 | (Example 21) | 13 | dye (3) | Charge transport layer 4b | 0.77 |
| Example 59 | (Example 22) | 10 | dye (3) | Charge transport layer 4b | 0.72 |
| Example 60 | (Example 23) | 14 | dye (3) | Charge transport layer 4b | 0.89 |
| Example 61 | (Example 23) | 12 | dye (1,3) | Charge transport layer 4a | 0.85 |
| Example 62 | (Example 24) | 11 | dye (1) | Charge transport layer 4a | 0.79 |
| Example 63 | Example 24) | 12 | dye (2) | Charge transport layer 4b | 0.85 |
| Example 64 | (Example 24) | 10 | dye (3) | Charge transport layer 4b | 0.89 |
| Example 65 | (Example 24) | 11 | dye (1,3) | Charge transport layer 4a | 0.82 |
| Example 66 | (Example 25) | 13 | dye (3) | Charge transport layer 4b | 0.75 |
| Example 67 | (Example 26) | 10 | dye (3) | Charge transport layer 4b | 0.75 |
| Example 68 | (Example 27) | 11 | dye (3) | Charge transport layer 4b | 0.72 |
| Example 69 | (Example 28) | 13 | dye (3) | Charge transport layer 4b | 0.71 |
| Example 70 | (Example 29) | 12 | dye (3) | Charge transport layer 4b | 0.74 |
| Comparative Example 1 | (comparative Example 1) | 11 | dye (3) | Charge transport layer 4b | 0.65 |

As apparent from Table 3, the dye-sensitized solar cell using a photoelectric conversion device of the present invention generates a high open circuit voltage of 0.71 or more. Especially, the one using the modified titanium oxide microparticle modified with zirconium or aluminium generates a high open circuit voltage of 1 or more. In this way, the dye-sensitized solar cells using the photoelectric conversion device of the present invention have a high open circuit voltage, and therefore, when incorporated into portable electric appliances, such as a calculator and a mobile phone, which function only with a voltage greater than or equal to a specified value and with a minimum electric current, the number of cells connected in a series may be few and the manufacturing cost of the electric appliances or the like may be reduced.

BRIEF DESCRIPTION OF THE DRAWING

Fig. 1 is the cross sectional view of a principal part of an example of a dye sensitized photoelectric conversion device of the present invention.

Description of Reference Numerals

Reference numeral 1 represents a conductive substance, reference numeral 2 represents a semiconductor metal layer, reference numeral 3 represents a counter electrode, reference numeral 4 represents a charge transfer layer, and reference numeral 5 represents a sealant, and reference numeral 6 represents a substrate (glass support), respectively.

## Claims

1. A modified titanium oxide microparticle comprising: titanium oxide and one or two or more nontitanic metal oxides, including silicon oxide, selected from the group consisting of oxides of elements of Group IB, Group IIA, Group IIB, Group IIIA, Group IIIB, Group IVA other than titanium, Group IVB, Group VIA and Group VIII of the periodic table and vanadium oxide.

2. The modified titanium oxide microparticle according to claim 1, wherein the nontitanic metal oxide, including silicon oxide, is one or two members selected from the group consisting of magnesium oxide, calcium oxide, strontium oxide, zirconium oxide, tantalic oxide, chromic oxide, molybdic oxide, niobic oxide, scandium oxide, vanadium oxide, iron oxide, nickel oxide, tungsten oxide, zinc oxide, aluminum oxide, indium oxide, silicon oxide and tin oxide.

3. The modified titanium oxide microparticle according to claim 1 or 2, wherein the titanium oxide is of anatase.

4. The modified titanium oxide microparticle according to any one of claims 1 to 3, wherein a proportion of the titanium oxide to the nontitanic metal oxides other than titanium oxide but including silicon oxide, expressed by an atomic ratio of titanium/nontitanium metal atom including silicon atoms, ranges from 1/0.02 to 1/0.5.

5. A method of manufacturing a modified titanium oxide microparticle comprising titanium oxide and nontitanic metal oxide including silicon oxide, comprising the step of reacting a titanium alkoxide with an alkoxide of one or two or more nontitanium metals, including silicon, selected from the group consisting of metals of Group IIA, Group IIB, Group IIIA, Group IIIB, Group IVA other than titanium, Group IVB and Group VA of the periodic table in an organic solvent.

6. The method of manufacturing a modified titanium oxide microparticle according to claim 5, wherein the organic solvent is an alcohol solvent.

7. The method of manufacturing a modified titanium oxide microparticle according to claim 6, wherein the alcohol solvent is a monohydric alcohol or a polyhydric alcohol.

8. The method of manufacturing a modified titanium oxide microparticle according to claim 7, wherein the polyhydric alcohol is 1,4-butanediol.

9. A dye-sensitized photoelectric conversion device comprising:

    a first conductive support having a semiconductor-containing layer sensitized with a dye;
    a second conductive support having a counter electrode disposed oppositely to the first conductive support at a predetermined interval; and
    a charge transfer layer interposed in a gap between the first and second conductive supports,
    wherein the semiconductor-containing layer contains the modified titanium oxide microparticle according to any one of claims 1 to 4.

10. The dye-sensitized photoelectric conversion device according to claim 9, wherein a mean particle diameter of a primary particle of the modified titanium oxide microparticle ranges from 1 to 1000 nm.

**11.** The dye-sensitized photoelectric conversion device according to claim 9 or 10, wherein the dye is a methine dye.

**12.** The dye-sensitized photoelectric conversion device according to claim 9 or 10, wherein the dye is a combination of a methine dye and a metal complex dye.

**13.** A dye-sensitized photoelectric conversion device comprising:

a first conductive support having a semiconductor-containing layer sensitized with a dye;
a second conductive support having a counter electrode disposed oppositely to the first conductive support at a predetermined interval; and
a charge transfer layer interposed in a gap between the first and second conductive supports,
wherein the semiconductor-containing layer contains a modified titanium oxide microparticle comprising titanium oxide and either niobic oxide or tantalic oxide obtained by the method according to any one of claims 5 to 8.

**14.** The dye-sensitized photoelectric conversion device according to claim 13, wherein the dye is a methine dye.

**15.** The dye-sensitized photoelectric conversion device according to claim 13, wherein the dye is a combination of a methine dye and a metal complex dye.

FIG. 1

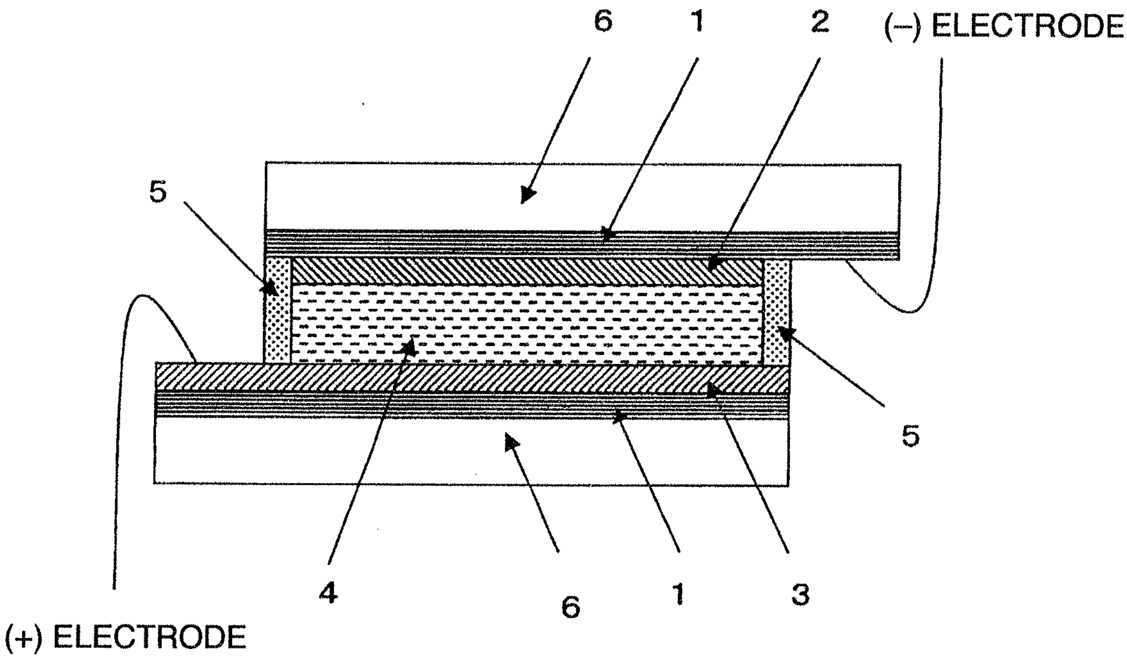

## INTERNATIONAL SEARCH REPORT

International application No.
PCT/JP2006/301199

A. CLASSIFICATION OF SUBJECT MATTER
***H01M14/00***(2006.01), ***H01L31/04***(2006.01)

According to International Patent Classification (IPC) or to both national classification and IPC

B. FIELDS SEARCHED

Minimum documentation searched (classification system followed by classification symbols)
H01M14/00, H01L31/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)
WPI/L

C. DOCUMENTS CONSIDERED TO BE RELEVANT

| Category* | Citation of document, with indication, where appropriate, of the relevant passages | Relevant to claim No. |
|---|---|---|
| X<br>Y | JP 2003-251194 A (Japan Science and Technology Corp.), 09 September, 2003 (09.09.03), Claims; Par. Nos. [0013], [0052] to [0054], [0058] to [0060], [0067] & WO 03/068684 A1 Claims; examples 2, 5, 14 | 1-10,13<br>11-12,14-15 |
| X | JP 2003-249279 A (Sharp Corp.), 05 September, 2003 (05.09.03), Claims; Par. Nos. [0022] to [0024], [0043], [0047], [0052], [0066] (Family: none) | 1-4,9-12 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 19 April, 2006 (19.04.06) | 25 April, 2006 (25.04.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.
PCT/JP2006/301199

C (Continuation). DOCUMENTS CONSIDERED TO BE RELEVANT

| Category* | Citation of document, with indication, where appropriate, of the relevant passages | Relevant to claim No. |
|---|---|---|
| X | JP 2003-272723 A (Toshiba Corp.), 26 September, 2003 (26.09.03), Claims; Par. Nos. [0018] to [0023], [0029], [0041] to [0048] (Family: none) | 1-4,9-11 |
| X | JP 2004-47264 A (Sharp Corp.), 12 February, 2004 (12.02.04), Claims; Par. Nos. [0020], [0025] to [0028], [0047] (Family: none) | 1-2,4,9-11 |
| Y | JP 2005-19130 A (Nippon Kayaku Co., Ltd.), 20 January, 2005 (20.01.05), Claims; Par. No. [0055] (Family: none) | 11-12,14-15 |
| Y | JP 2005-19124 A (Konica Minolta Holdings Kabushiki Kaisha), 20 January, 2005 (20.01.05), Claims; Par. Nos. [0078] to [0079] (Family: none) | 11-12,14-15 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2664194 B
- JP 2945955 B
- WO 2002011213 A
- WO 2002071530 A
- JP 2002334729 A
- JP 2003007358 A
- JP 2003017146 A
- JP 2003086257 A
- JP 2003059547 A
- JP 2003115333 A
- JP 2003132965 A
- JP 2003142172 A
- JP 2003151649 A
- JP 2003157915 A
- JP 2003282165 A
- JP 2004014175 A
- JP 2004022222 A
- JP 2004320699 A
- JP 2005111696 A
- JP 2005151422 A
- JP 2005173429 A
- JP 2005177087 A


### Non-patent literature cited in the description


- *J. Am. Chem. Soc.,* 1993, vol. 115, 6382